# DEMANDE DE BREVET EUROPEEN

(11) **EP 0 718 417 A1**
(43) Date de publication de la demande: **26.06.1996**
(21) Numéro de dépôt: 95402850.2
(22) Date de dépôt: 18.12.1995
(51) Int. Cl.: C23C 14/02, C23C 16/02, C23C 14/06, C23C 16/26

(54) **Matériau multicouche**

(30) Priorité: 20.12.1994 FR 9415311
(71) Demandeur: COMMISSARIAT A L'ENERGIE ATOMIQUE, 75015 Paris (FR)
(72) Inventeur: Quesnel, Etienne, F-38240 Meylan (FR); Ernoult, Jacques, F-38960 Saint-Etienne de Crossey (FR); Rivoallan, Annie, F-38100 Grenoble (FR)
(74) Mandataire: Dubois-Chabert, Guy

(57) **Abrégé**

L'invention concerne un matériau multicouche comprenant une couche d'interface assurant l'adhérence d'un revêtement mince à base de carbone sur un substrat en alliage à base de titane et un procédé de fabrication dudit matériau.

Le but de l'invention est de réaliser une couche d'interface améliorant l'adhérence du revêtement sur le substrat.

Ce but est atteint à l'aide d'une couche présentant simultanément, depuis le substrat jusqu'au revêtement mince à base de carbone, un gradient croissant de la concentration en carbone et un gradient décroissant de la concentration des éléments constituant le substrat, et présentant une épaisseur comprise entre environ 10 et 50 nm, cette épaisseur correspondant à la zone où le gradient de la concentration en carbone passe de 16 à 100%.

Application aux matériaux utilisés dans le domaine médical.

## Description

L'invention concerne un matériau multicouche comprenant une couche d'interface assurant l'adhérence d'un revêtement mince à base de carbone sur un substrat en alliage à base de titane, ainsi que le procédé de fabrication de ce matériau.

Dans tout système mécanique où des surfaces en contact sont en mouvement l'une par rapport à l'autre, le frottement constitue un obstacle majeur aux performances et à la fiabilité des mécanismes en mouvement. L'utilisation de lubrifiant liquide constitue dans la majorité des cas, une réponse satisfaisante à ce problème. Cependant, pour certaines applications, il est nécessaire, soit d'avoir recours à un lubrifiant solide si l'utilisation de liquide est proscrite, (c'est le cas dans le domaine spatial par exemple), soit de renforcer les surfaces en contact par un matériau protecteur anti-friction et anti-usure, afin de prolonger la durée de vie des pièces mobiles, que celles-ci se trouvent en milieu lubrifié ou non.

Ces matériaux lubrifiants ou anti-usure se présentent sous la forme de revêtements dont l'épaisseur est typiquement comprise entre quelques dixièmes et quelques dizaines de microns. Ils regroupent pour l'essentiel :
- les métaux mous (argent, or ou plomb) ainsi que des composés lamellaires tels que des composés de bisulfure, (notamment les bisulfures de molybdène ou de tungstène), ces matériaux constituant des revêtements à fonction lubrifiante, et
- les matériaux durs tels que les nitrures de titane ou de chrome, les carbures de chrome, de molybdène ou de tungstène ou encore le borure de titane, ces matériaux constituant des revêtements anti-usure.

Par ailleurs, on connaît également les revêtements minces à base de carbone présentant un excellent comportement anti-usure et anti-friction. Ces revêtements minces sont décrits notamment par A. Grill, V. Patel et B. Meyerson, Surf. and Coat. Technol., 49 (1991) 530-536, par Kayuzuki Oguri et Tohru Arai, Surf. and Coat. Technol., 47 (1991) 710-721, et par R. d'Agostino, R. Lamendola et P. Favia, J. Vac. Technol. A12(2) Mars/Avril 1994, 308-313. Ces revêtements à base de carbone regroupent :
- les couches dures de carbone amorphe pur [a.C] connues encore sous l'appellation de carbone type diamant, et
- les couches de carbone fortement dopé tel que le carbone hydrogéné [a.C-H], le carbone azoté [a.C-N] ou le carbone fluoré [a.C-F], par exemple et
- les composés du type a.Si-[C-H], a.B-[C-H], a.BN-[C-H], a.Si-[C-F], etc...

Ces revêtements à base de carbone sont utilisés par exemple sur des pièces mécaniques en alliage à base de titane soumises à l'usure et/ou frottement et permettent d'augmenter grandement la durée de vie ou l'échauffement de ces pièces. Ce type de revêtement est également très souvent utilisé dans le domaine médical sur des prothèses de type valve cardiaque, prothèse de genou, etc... pour assurer le rôle de bio- ou hémocompatibilité ainsi que la résistance à l'usure des pièces ainsi revêtues.

Tous ces revêtements sont généralement déposés par des techniques de dépôt sous vide qui permettent de former des couches minces d'une épaisseur nécessaire, variant entre 0,01 µm et quelques microns. Les procédés de dépôt utilisés font appel principalement aux différentes technologies sous vide suivantes :
- le dépôt chimique en phase vapeur (CVD) assisté par plasma généré par une excitation radiofréquence, micro-onde, voire même continue. Dans ce cas, le carbone provient de la décomposition d'un gaz d'hydrocarbure ;
- le dépôt physique en phase vapeur (PVD) qui consiste en la pulvérisation d'une cible de graphite ou en l'évaporation du graphite. Pour favoriser la densification de ces revêtements, ces procédés peuvent également être assistés par un bombardement ionique annexe souvent généré par un canon à ions, connu sous la terminologie anglaise : "Ion Beam Assisted Deposition" ; ou
- le dépôt utilisant une source d'ions carbone qui sont accélérés par une optique ionique adaptée en direction des surfaces à recouvrir.

Si l'intérêt de ces revêtements minces à base de carbone est certain, il n'en reste pas moins que le développement de leur utilisation a été freiné par leur manque d'adhérence sur le substrat qu'ils revêtent. Ce manque d'adhérence compromet leurs qualités tribologiques et diminue leur fiabilité de fonctionnement. Cette difficulté à faire adhérer un revêtement à base de carbone sur un substrat est particulièrement sensiblement dans le cas d'un substrat à base de titane.

Le problème d'adhérence entre le carbone et le substrat métallique est principalement lié à deux facteurs :
- la présence dans les revêtements minces à base de carbone, de contraintes internes de compression relativement importantes, de l'ordre de 0,5 à 3 GPa qui s'opposent aux forces de liaison entre le carbone et le substrat,
- la difficulté pour les éléments qui composent le substrat métallique de former des liaisons chimiques stables avec le carbone.

Le premier facteur peut être maîtrisé en diminuant les contraintes internes de la couche de revêtement. Pour cela, il est nécessaire de faire appel à des méthodes d'optimisation des procédés de dépôt, décrit notamment par H. Windischmann, Critical Reviews in Solid State and Materials Sciences, 17(6) : 547-596 (1992). Ces procédés de dépôt permettent de limiter le risque de décollement du revêtement de carbone. Toutefois, de tels procédés s'accompagnent inévitablement d'une modification des propriétés intrinsèques du revêtement à base de carbone pouvant aller jusqu'à le rendre incompatible avec l'application visée. Ainsi, par exemple il est connu que le fait de déposer le revêtement à haute pression diminue considérablement ses contraintes internes. On obtient alors un matériau adhérent mais inadapté à une application frottement anti-usure car trop mou.

Il est donc préférable d'essayer d'agir sur le deuxième facteur en créant des liaisons solides chimiques à l'interface entre le revêtement à base de carbone et le substrat métallique. Les solutions généralement proposées consistent à rajouter une couche intermédiaire entre le substrat métallique et le revêtement de carbone. Cette couche intermédiaire contient un élément chimique connu pour sa capacité à se lier facilement aussi bien avec les éléments du substrat qu'avec le carbone.

Ainsi, A. Grill, B. Meyerson et V. Patel, J. Mater. Res., 3(2) Mars/Avril 1988, décrivent l'emploi d'une sous-couche intermédiaire très fine de silicium, inférieure à 100 Å, pour améliorer l'adhérence du carbone sur des métaux tels que le cobalt, le chrome ou leurs alliages. Dans l'empilement obtenu, la liaison Si-C se fait facilement et la liaison métal-Si est réalisée par la formation locale de siliciure métallique sur quelques couches atomiques. Néanmoins, l'adhérence du carbone sur le substrat par l'intermédiaire de cette sous-couche se dégrade dès que la sous-couche de silicium dépasse 100 Å car alors la couche de siliciure devient trop épaisse.

Le document US 5 249 554 divulgue l'emploi de couches intermédiaires en silicium, carbure de silicium ou en bore pour assurer l'interface entre un substrat et une couche à base de carbone. Le document JP 3 291 378 décrit l'emploi de couches intermédiaires à base de carbure de titane, de zirconium ou d'hafnium pour des applications tribologiques du carbone sous forme de couches minces.

Le document DE 4 211 829 décrit une solution plus complexe utilisant deux couches intermédiaires successives entre le substrat et la couche de carbone. La première couche intermédiaire se compose d'un carbure ou d'un nitrure de titane selon une composition stoechiométrique et la deuxième couche intermédiaire se compose de titane à gradient de composition. Enfin, les documents JP 2149673 et JP 5311444 divulguent également l'emploi de deux couches intermédiaires successives telles que par exemple (métal pur : titane, aluminium ou fer/Si-C) ou (Ti-C, Ti-N/Si ou Ge).

Dans tous les cas précités, on utilise donc une couche intermédiaire à une ou deux sous-couches, ce qui entraîne une multiplication des interfaces et paradoxalement de ce fait, une augmentation des risques potentiels de rupture d'adhérence entre ces différentes sous-couches.

L'invention a pour but de résoudre les inconvénients de l'art antérieur précité.

A cet effet, l'invention concerne un matériau multicouche comprenant un substrat en alliage de titane recouvert d'une couche d'interface assurant l'adhérence d'un revêtement mince à base de carbone sur ledit substrat. Selon les caractéristiques de l'invention, cette couche d'interface présente simultanément, depuis le substrat jusqu'au revêtement mince à base de carbone, un gradient croissant de la concentration en carbone et un gradient décroissant de la concentration des éléments constituant le substrat, et elle présente une épaisseur comprise entre environ 10 et 50 nm dans la zone où le gradient de la concentration en carbone passe de 16 à 100%.

La valeur de 16% est donnée par référence aux valeurs de mesure utilisées en spectroscopie de masse aux ions secondaires (SIMS).

L'expression "revêtement mince" correspond à une couche d'une épaisseur inférieure à 50 µm.

Les termes à base de carbone recouvrent le revêtement comprenant majoritairement du carbone, c'est-à-dire par exemple le carbone fortement dopé tel que le carbone hydrogéné [a.C-H], le carbone azoté [a.C-N] ou le carbone fluoré [a.C-F], les composés du type a.Si-[C-H], a.B-[C-H], a.BN-[C-H], a.Si[C-F], etc... ou encore le carbone amorphe pur [a.C] connu encore sous l'appellation de carbone type diamant.

La couche d'interface permet d'assurer une très bonne adhérence du revêtement mince sur le substrat. En effet, l'accrochage du revêtement mince est réalisé par une couche d'interface à structure graduelle ne contenant pas d'autres éléments chimiques que ceux du substrat ou de la couche de carbone. Cela minimise en particulier les problèmes mécaniques que l'on peut rencontrer avec les structures multicouches hétérogènes décrites précédemment dans l'art antérieur où des phénomènes de dilatation thermique différentielle peuvent se produire, voire même une mise en contrainte excessive de la couche de carbone par la sous-couche intermédiaire, ce qui conduit à la fissuration ou à la destruction du revêtement de carbone. En outre, la couche d'interface étant monocouche, on réduit les risques de rupture d'adhérence qui se produisent généralement au niveau des interfaces.

L'invention concerne également un procédé de fabrication d'un matériau multicouche comprenant un substrat en alliage à base de titane recouvert d'un revêtement mince à base de carbone. Selon les caractéristiques de l'invention, ce procédé comprend les étapes suivantes consistant à :
- placer le substrat dans une enceinte sous vide,
- effectuer un décapage dudit substrat pour éliminer les contaminants et les oxydes de surface,
- diriger vers ledit substrat un flux combiné d'atomes constituant le revêtement mince à base de carbone et d'ions d'un gaz rare, l'énergie de ces ions étant comprise entre environ 1 et 4 kV, le rapport entre le flux d'ions énergétiques de gaz rare et le flux des atomes constituant le revêtement étant compris entre 0,5 et 5, jusqu'à ce que le rapport entre les flux devienne inférieur à 0,5, de façon à former sucessivement une couche d'interface et le revêtement mince à base de carbone, ladite couche d'interface assurant l'adhérence dudit revêtement sur le substrat.

La combinaison des flux induit simultanément d'une part la pulvérisation du substrat, en particulier des atomes d'oxygène liés au titane, d'autre part un apport de carbone qui se substitue aux atomes d'oxygène pour former des liaisons Ti-C. Cette substitution est rendue possible par la simultanéité des deux phénomènes. La croissance de l'interface est possible dans la mesure ou pour un rapport de flux compris entre 0,5 et 5, on apporte plus de carbone qu'on enlève d'éléments du substrat.

Lorsque le rapport des flux est voisin de 5, on favorise la pénétration en profondeur du carbone et des atomes constituant le revêtement, mais ceux-ci sont présents en moins grande quantité. Le gradient de la concentration en carbone s'accroît plus lentement et l'épaisseur de l'interface est assez importante. Inversement, lorsque le rapport des flux est voisin de 0,5, l'épaisseur de l'interface est plus faible.

Les liaisons de type Ti-C sont obtenues dans une proportion nettement supérieure à celle observée dans le cas d'un dépôt classique sur un substrat décapé.

De façon avantageuse, le décapage est un décapage ionique réalisé en plaçant le substrat dans l'enceinte à vide où a lieu le dépôt du revêtement à base de carbone, et en bombardant ledit substrat à l'aide d'ions issus d'un plasma de gaz rare et maintenus sous une tension comprise entre environ 1 et 10 kV.

Grâce à ces caractéristiques de l'invention, on limite la contamination au niveau des interfaces, puisque tout le procédé (c'est-à-dire le décapage ionique du substrat, le dépôt de la couche d'interface et le dépôt du revêtement à base de carbone) se fait de façon continue à l'intérieur d'une enceinte fermée, sans interruption. Dans l'art antérieur, l'interruption du procédé était occasionnée par le dépôt de plusieurs sous-couches de matériaux différents. Cette contamination aux interfaces est généralement responsable de la dégradation de l'adhérence. Par ailleurs, le procédé selon l'invention est simplifié par l'emploi d'une interface graduelle qui permet de s'affranchir de l'utilisation délicate de pièges à oxygène pour limiter l'oxydation des substrats en particulier lors de la phase de décapage ionique.

De préférence, le gaz rare utilisé aussi bien dans le décapage ionique que dans la formation de la couche d'interface est de l'argon.

De préférence, pour déposer le revêtement mince à base de carbone, le rapport entre les flux est d'environ 0,1.

Le flux d'atomes de carbone est formé soit par dépôt physique en phase vapeur par pulvérisation ou évaporation d'une source de carbone, généralement du graphite, soit par dépôt chimique en phase vapeur assisté ou non par un plasma généré par excitation radiofréquence, microonde ou continue. Le flux d'ions de gaz rare provient avantageusement d'un canon à ions ou peut être formé par extraction à partir du plasma de pulvérisation.

L'invention sera mieux comprise à la lecture de la description suivante d'un mode de réalisation de l'invention, donné à titre d'exemple illustratif et non limitatif, cette description étant faite en faisant référence aux dessins joints, dans lesquels :

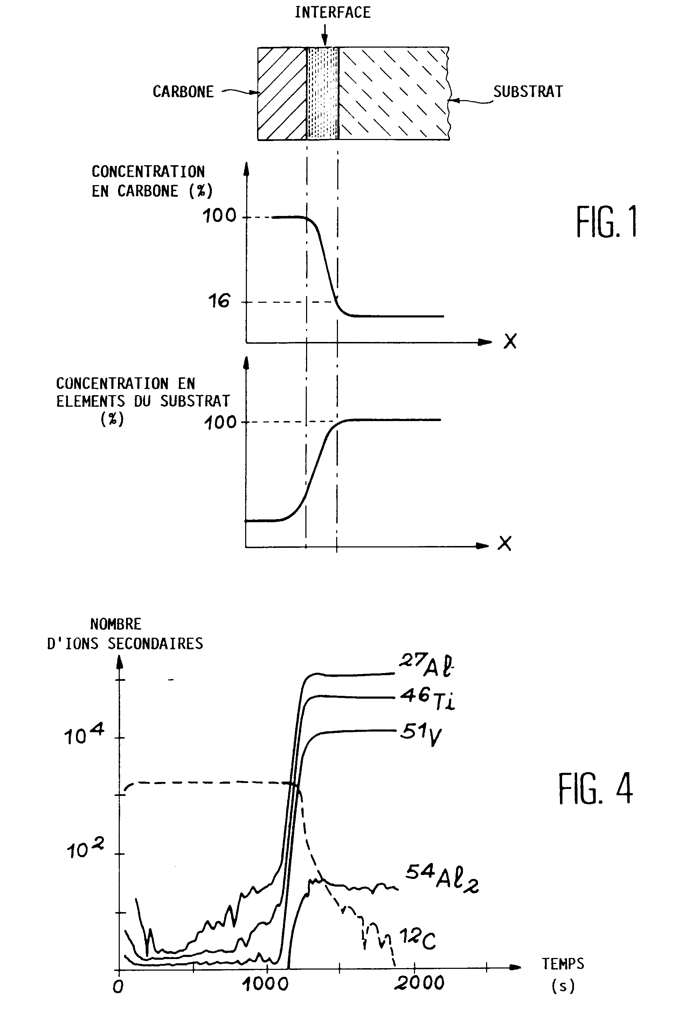

- la figure 1 est un schéma illustrant la variation de la concentration en carbone et de la concentration en éléments du substrat à l'intérieur de la couche d'interface,
- les figures 2A et 2B illustrent respectivement des courbes de frottement et d'acoustique enregistrées lors de tests d'adhérence effectués respectivement sur un substrat recouvert d'une couche de carbone présentant la couche d'interface selon l'invention, (ci-après dénommé échantillon 1) et sur un substrat recouvert d'une couche de carbone selon l'art antérieur (ci-après dénommé échantillon 2) ;
- les figures 3A et 3B représentent des profils d'analyse obtenus par spectroscopie de masse aux ions secondaires, respectivement pour les échantillons 1 et 2 ;
- la figure 4 est une courbe illustrant les résultats obtenus par spectroscopie de masse aux ions secondaires, sous oxygène pour l'échantillon 1 ; et
- les figures 5A et 5B représentent des courbes d'analyse chimique obtenues par spectroscopie électronique, respectivement pour les échantillons 1 et 2.

On donne ci-après un exemple d'un mode de réalisation de l'invention.

### Exemple 1

Une couche d'interface assurant l'adhérence d'un revêtement en carbone sur un substrat d'alliage TA6V (alliage de titane, d'aluminium et de vanadium) réalisé par le procédé selon l'invention.

La première phase de décapage est réalisée par décapage ionique classique pendant une durée de 20 minutes par un plasma diode que l'on établit entre le substrat (cathode polarisée à -2000 V) et un cache placé entre celui-ci et les cibles de carbone. Ce cache constitue une anode et est relié à la masse.

Ensuite, on effectue le dépôt de la couche d'interface pendant une durée de 20 minutes. On utilise un procédé de dépôt physique en phase vapeur, plus précisément la pulvérisation cathodique magnétron sous une atmosphère d'argon pur. La cible de graphite est pulvérisée sous une densité de puissance de pulvérisation de 0,5 W/cm², le substrat n'étant alors plus protégé par le cache mais restant polarisé à -2000 V. Dans ces conditions, au niveau de la surface des substrats, le rapport des flux incidents d'atomes de carbone et d'ions argon énergétiques a été mesuré et vaut 1,25.

Enfin, après cette deuxième phase, on procède dans la continuité au dépôt du revêtement de carbone. Pour cela, on supprime la forte polarisation du substrat et l'on augmente la densité de puissance de pulvérisation de la cible de graphite jusqu'à une valeur de 25 W/cm². Dans ces conditions, la vitesse moyenne du dépôt de carbone est d'environ 0,8 µm/h.

### Tests d'évaluation de l'adhérence

Pour mettre en évidence l'effet positif de la couche d'interface selon l'invention sur l'adhérence, deux types d'échantillon ont été préparés et comparés. Le premier échantillon (ci-après échantillon 1) comporte la couche d'interface selon l'invention et le deuxième échantillon (ci-après échantillon 2) n'a subi qu'un décapage ionique classique du substrat d'environ 20 minutes puis un dépôt de carbone par pulvérisation cathodique magnétron sous atmosphère d'argon pur.

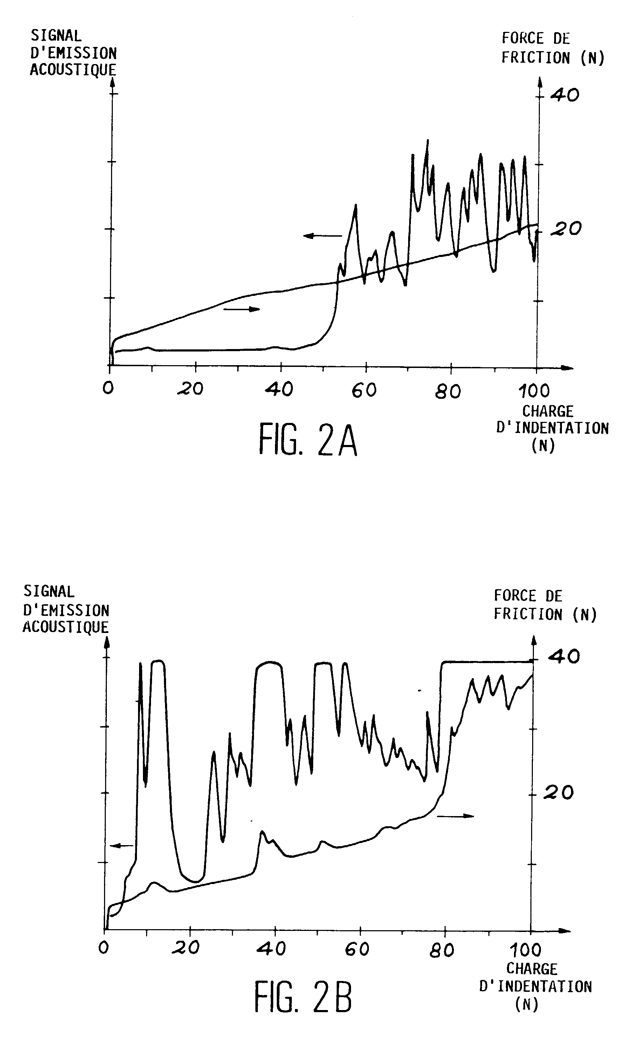

L'évaluation de l'adhérence du revêtement mince à base de carbone a été faite en utilisant le test de la rayure et le dispositif de "Scratch Test" développé par la Société CSEM. Les conditions de test sont identiques pour les deux échantillons et utilisent une bille en alumine, d'un diamètre de 8 mm, comme indenteur pour limiter la pression de contact. Le test effectué consiste à rayer la surface du revêtement en augmentant progressivement la charge d'appui imprimée à la bille au cours du déplacement de celle-ci. Pendant cette opération, simultanément, on enregistre par détection acoustique le signal émis lors de la rupture d'adhérence de la couche par rapport à son substrat. Les résultats obtenus sont illustrés sur les figures 2A (échantillon 1) et 2B (échantillon 2).

On voit clairement que dans l'échantillon 2, le revêtement mince en carbone est peu adhérent au substrat puisque l'intensité du signal acoustique enregistré est très importante dès l'apparition de faibles charges d'indentation (quelques Newtons) . A l'inverse, pour l'échantillon 1, il faut attendre une charge d'indentation de 50 N pour commencer à observer une séparation entre le revêtement mince de carbone et le substrat à base de titane. Ces résultats sont très reproductibles d'un échantillon à l'autre et ont été confirmés par l'observation optique de la rayure.

Ceci montre donc que la couche d'interface selon l'invention améliore sensiblement l'adhérence du dépôt de carbone sur le substrat.

Pour expliquer davantage le rôle bénéfique de la couche d'interface, une étude approfondie a été effectuée par des analyses obtenues par Spectroscopie de Masse aux Ions Secondaires (SIMS) et par Analyse Chimique par Spectroscopie Electronique (ESCA).

### Analyse par SIMS

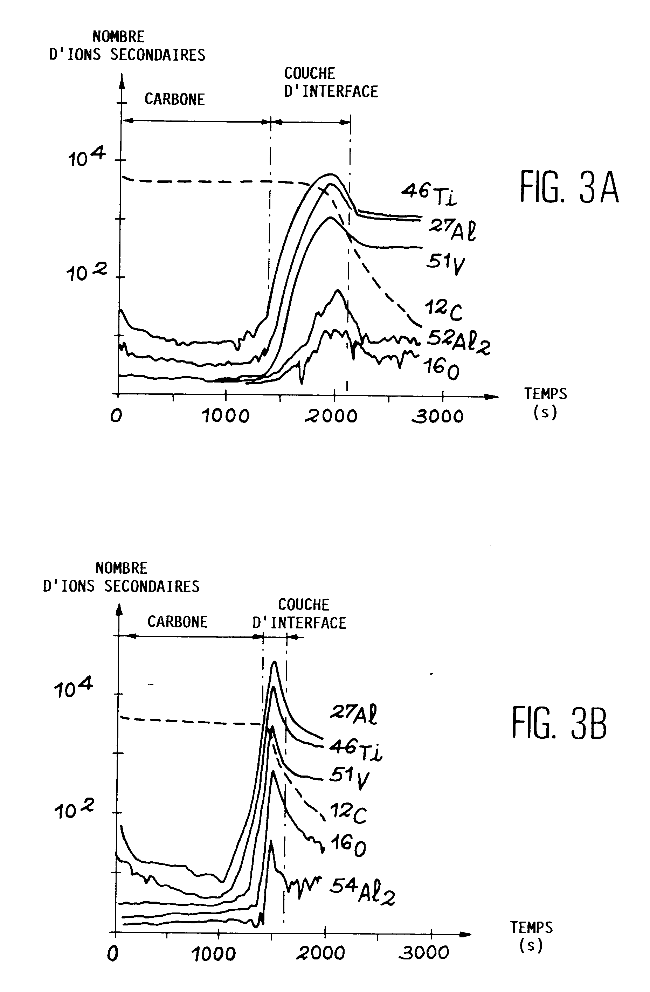

Les profils de concentration obtenus par SIMS pour les échantillons 1 et 2 précités sont illustrés respectivement sur les figures 3A et 3B. Ces mesures ont été effectuées dans des conditions opératoires rigoureusement identiques notamment en ce qui concerne la vitesse d'attaque des couches par érosion ionique. Une source de césium a été utilisée et le rapport zone balayée/zone analysée était égal à 250/60. Le revêtement de carbone a la même épaisseur pour les deux échantillons, soit 50 nm.

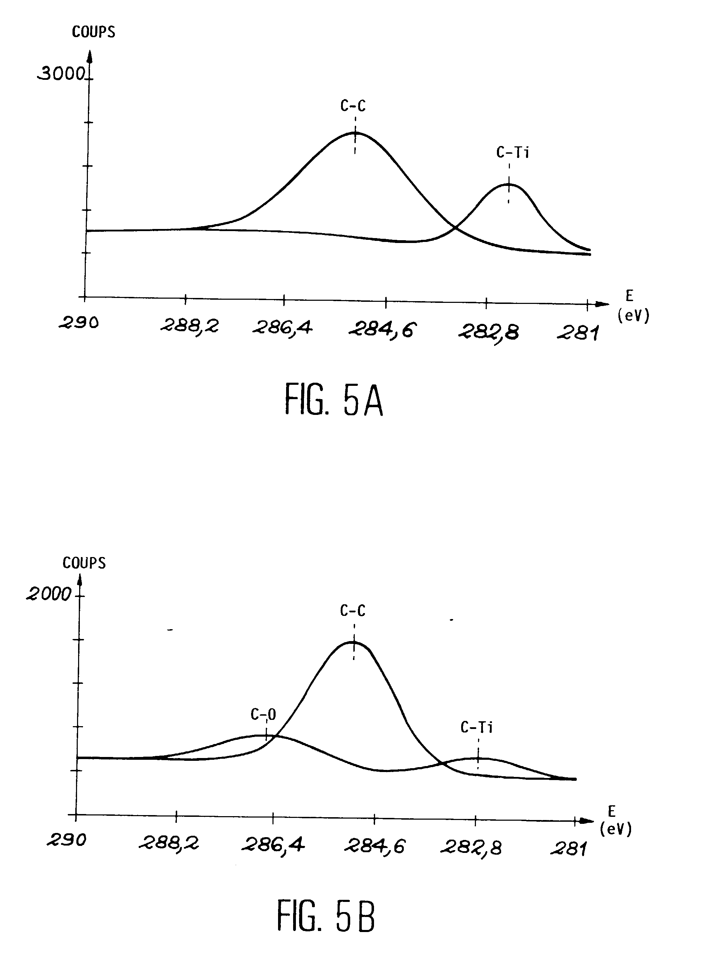

On observe que la transition entre la couche de carbone et le substrat, correspondant à l'apparition des éléments du substrat Ti, Al et V se fait brutalement dans le cas de l'échantillon 2 et très progressivement dans le cas de l'échantillon 1. Par ailleurs, l'interface graduelle d'accrochage est nettement mise en évidence dans l'échantillon 1 où la coexistence des éléments du substrat (Ti, Al et V) et du carbone se fait sur une large zone, ce qui n'est pas le cas de l'échantillon 2. Compte tenu de la vitesse d'érosion utilisée, l'épaisseur de l'interface dans l'échantillon 1 a été estimée à 30 nm alors que l'épaisseur de l'interface dans l'échantillon 2 est de 7 nm. De plus, la quantité d'oxygène détectée est plus importante pour l'échantillon 2 que pour l'échantillon 1. On notera enfin que la forme particulière des profils de concentration de Ti, Al et V est caractéristique de la présence dans l'interface de ces éléments sous forme d'oxyde. Les mêmes mesures effectuées sous soufflage d'oxygène, voir la figure 4, le confirment. En effet, dans ces conditions, le rendement ionique de Ti, Al, V reste constant lors du passage de la couche d'interface vers le substrat, ce qui conduit dans cette zone d'analyse à un profil plat.

### Analyse par ESCA

L'analyse comparative par ESCA des couches d'interface des échantillons 1 et 2, en ce qui concerne les liaisons C-C et C-Ti est illustrée respectivement sur les figures 5A et 5B et fournit une explication à l'amélioration d'adhérence de l'interface selon l'invention. Ces spectres ont été enregistrés après érosion des couches jusqu'au niveau de la zone d'interface proche du substrat où le signal SIMS du carbone a chuté de 70% par rapport au signal dans la couche de carbone. Pour l'échantillon 2, la déconvolution du spectre fait apparaître trois pics d'énergie 282,79 eV, 285,13 eV et 286,63 eV que l'on peut attribuer respectivement aux liaisons C-Ti, C-C et C-O. Pour l'échantillon 1, la déconvolution du spectre fait apparaître deux pics seulement d'énergie 282,53 eV et 285,25 eV, que l'on peut attribuer respectivement aux liaisons C-C et C-Ti. En d'autres termes, on note une absence de liaison C-O. De plus, le pic C-Ti est particulièrement bien résolu. On peut donc considérer que dans l'échantillon 2, la liaison C-O est réalisée au détriment de la liaison C-Ti.

Le dépôt de la couche d'interface par le procédé selon l'invention permet donc non seulement de limiter la présence d'oxygène au niveau de la couche d'interface mais surtout d'augmenter considérablement le taux de liaisons C-Ti qui apparaît nettement dans les spectres ESCA. Ainsi, pour un même taux résiduel de carbone de 30%, le rapport des liaisons R=C-Ti/C-C est beaucoup plus important dans le cas de l'échantillon 1 (R=0, 37) que dans l'échantillon 2 (R=0,14).

## Revendications

1. Matériau multicouche comprenant un substrat en alliage à base de titane recouvert d'une couche d'interface et d'un revêtement mince à base de carbone, caractérisé en ce que la couche d'interface présente simultanément, depuis le substrat jusqu'au revêtement mince à base de carbone, un gradient croissant de la concentration en carbone et un gradient décroissant de la concentration des éléments constituant le substrat, et en ce que cette couche d'interface présente une épaisseur comprise entre environ 10 et 50 nm, cette épaisseur correspondant à la zone où le gradient de la concentration en carbone passe de 16 à 100%.

2. Procédé de fabrication d'un matériau multicouche comprenant un substrat en alliage en base de titane recouvert d'un revêtement mince à base en carbone, caractérisé en ce qu'il comprend les étapes suivantes consistant à :
- placer le substrat dans une enceinte sous vide,
- effectuer un décapage dudit substrat pour éliminer les contaminants et les oxydes de surface,
- diriger vers ledit substrat un flux combiné d'atomes constituant le revêtement mince à base de carbone et d'ions d'un gaz rare, l'énergie de ces ions étant comprise entre environ 1 et 4 kV, le rapport entre le flux d'ions énergétiques de gaz rare et le flux des atomes constituant le revêtement étant compris entre 0,5 et 5, jusqu'à ce que le rapport entre les flux devienne inférieur à 0,5, de façon à former successivement une couche d'interface et le revêtement mince à base de carbone, ladite couche d'interface assurant l'adhérence dudit revêtement sur le substrat.

3. Procédé de fabrication selon la revendication 2, caractérisé en ce que le décapage est un décapage ionique réalisé en plaçant le substrat dans l'enceinte à vide où a lieu le dépôt du revêtement à base de carbone et en bombardant ledit substrat à l'aide d'ions issus d'un plasma de gaz rare et maintenus sous une tension comprise entre environ 1 et 10 kV.

4. Procédé de fabrication selon la revendication 2 ou 3, caractérisé en ce que le gaz rare est de l'argon.

5. Procédé de fabrication selon la revendication 2, caractérisé en ce que pour déposer le revêtement mince à base de carbone, le rapport entre les flux est d'environ 0,1.

6. Procédé de fabrication selon la revendication 2, caractérisé en ce que le flux d'atomes de carbone est formé par dépôt physique en phase vapeur par pulvérisation ou évaporation d'une source de carbone.

7. Procédé de fabrication selon la revendication 2, caractérisé en ce que le flux d'atomes de carbone est formé par dépôt chimique en phase vapeur.

8. Procédé de fabrication selon la revendication 2, caractérisé en ce que les ions de gaz rare proviennent d'un canon à ions ou sont extraits du plasma de pulvérisation.
